# EUROPEAN PATENT APPLICATION

(11) **EP 1 398 274 A1**
(43) Date of publication of application: **17.03.2004**
(21) Application number: 01941126.3
(22) Date of filing: 20.06.2001
(51) Int. Cl.: B65D 1/00, B65D 1/24, B65D 25/34, C08J 7/06, C23C 16/27

(54) **MOISTURE AND GAS BARRIER PLASTIC CONTAINER WITH PARTITION PLATES, AND DEVICE AND METHOD FOR MANUFACTURING THE PLASTIC CONTAINER**

(71) Applicant: MITSUBISHI SHOJI PLASTICS CORPORATION, Shinagawa-ku, Tokyo 141-8535 (JP); Youtec Co. Ltd., Nagareyama-shi, Chiba 270-0156 (JP)
(72) Inventor: HAMA, Kenichi, MITSUBISHI SHOJI PLASTICS CORP., Tokyo 141-8535 (JP); KAGE, Tsuyoshi, MITSUBISHI SHOJI PLASTICS CORP., Tokyo 141-8535 (JP); KOBAYASHI, Takumi, YOUTEC CO., LTD., Nagareyama-shi, Chiba 270-0156 (JP)
(74) Representative: Bunke, Holger, Dr.rer.nat. Dipl.-Chem.
(86) International application number: PCT/JP2001/005266
(87) International publication number: WO 2003/000558

(57) **Abstract**

The present invention provides a moisture and gas barrier plastic container with partition plates. In addition, this invention provides a manufacturing apparatus and a method of manufacturing for the container too. The manufacturing apparatus (100) of the present invention is an apparatus which forms a DLC film on inner wall surfaces (3) having an inside/outside relationship with respect to outer wall surfaces (2) of the plastic container equipped with partition plates (1), and partition plate wall surfaces (5) formed by the partition plates by a plasma CVD method. And this apparatus is characterized by having a vacuum chamber (6) which surrounds the plastic container (1) and also serves as an external electrode, a grounded internal electrode (8) which passes through the vacuum chamber (6) and is inserted into the inside of each compartment (7) inside the plastic container (1) formed by the inner wall surfaces (3) and the partition plate wall surfaces (5), a microwave supply means (20) which generates a source gas plasma inside the plastic container (1) by introducing microwaves inside the plastic container (1), a high-frequency output supply means (30) which is connected to the vacuum chamber (6) to generate a self-bias voltage at the inner wall surfaces (3) in order to control the ionic incident energy of the source gas plasma for the inner wall surfaces (3) or the partition plate wall surfaces (5), and a source gas supply means (40) which introduces a source gas into each compartment (7) inside the plastic container (1).

## Description

### TECHNICAL FIELD

The present invention is related to a plastic container equipped with partition plates in which a DLC (Diamond Like Carbon) film is coated on the inner wall surfaces of the plastic container, a manufacturing apparatus therefor, and a manufacturing method thereof. In particular, the forming of the DLC film is carried out by a plasma CVD (Chemical Vapor Deposition) method.

### PRIOR ART TECHNOLOGY

Japanese Laid-Open Patent Publication No. HEI 8-53117 discloses a film forming apparatus which uses a plasma CVD method to form a DLC film on the inner wall surfaces of a plastic container for the purpose of improving the gas barrier properties and the like of containers used as carbonated beverage and fruit juice containers and the like. This apparatus for manufacturing a DLC film coated plastic container is a high-frequency capacitive coupling type discharge system, and has the following characteristics. Namely, such system is equipped with a hollow-shaped external electrode having a space for housing a container in which the space forms a vacuum chamber and the external electrode is shaped roughly similar to the external shape of the container housed in the inner wall portion of the space, an insulating member which makes contact with the opening of a container and insulates the external electrode when the container is housed inside the space of the external electrode, a grounded internal electrode which is inserted from the opening of the container to the inside of the container housed inside the space of the external electrode, exhaust means which communicates inside the space of the external electrode to carry out exhaust of the container housed inside the space of the external electrode, and a high-frequency power supply connected to the vacuum chamber. In the publication described above, high-frequency waves are used as a plasma-generating energy source. The term high-frequency wave is a common expression, but in general is an electromagnetic wave in the range 100KHz ∼ 1000MHz. In the publication described above, there is no description of specific frequencies. Further, in general the high-frequency wave uses 13.56MHz which is an industrial frequency.

In the publication described above, after a vacuum of 10⁻² ∼ 10⁻⁵ torr is created inside the chamber, a source gas is introduced and the pressure is adjusted to 0.5 ∼ 0.001 torr, and then a high-frequency power of 50 ∼ 1000W, for example, is applied to form a DLC film on the inner wall surfaces of a plastic container. The film thickness of the DLC film is formed so as to be 0.05 ∼ 5µm.

### SUMMARY OF THE INVENTION

However, the problems described below are not solved by the technology described above. Namely, in the publication described above, the container is a bottle-shaped container, and so far there has been no plastic container in which a DLC film is formed on the inner wall surfaces of a container having a shape in which the inside of the container is partitioned into small compartments by partition plates.

It is a first object of the present invention to provide a moisture and gas barrier plastic container equipped with partition plates by forming a moisture and gas barrier DLC film on the inside wall surfaces of a plastic container equipped with partition plates, and forming a DLC film on the partition plate wall surfaces. In accordance with the present invention, by providing this container, it is possible to prevent the infiltration of moisture, oxygen, nitrogen, carbon dioxide gas, organic gases and the like from the outside, and it is possible to prevent the volatilization of the water and vaporized components contained in the contents. Each compartment inside the container may be filled with the same contents or different contents. The plastic container equipped with partition plates is primarily used as a food container such as a lunch box or the like, or a beverage container, and an ink cartridge for a recording printer having an ink jet recording system, a container for a simple analysis set and the like can form other examples, but there is no limit to the applications. The moisture and gas barrier properties of each partitioned compartment depends on the DLC film and the partition plates.

Further, the inner wall surfaces in the present invention refer to the wall surfaces having an inside/outside relationship with respect to the outer wall surfaces (including the bottom wall), and the partition plate wall surfaces refer to wall surfaces formed by the partition plates. In the present invention, these wall surfaces are distinct.

In this regard, the DLC film of the present invention is a film called an i-carbon film or an amorphous carbon hydride film (a - C : H), and also includes a hard carbon film. Further, a DLC film is an amorphous-state carbon film, and includes SP³ bonding and SP² bonding. Further, this film includes a DLC film containing the element silicon Si.

Further, the moisture and gas barrier DLC film in the present invention refers to a DLC film having a moisture barrier property for water vapor, and a gas barrier property for oxygen, carbon dioxide, nitrogen and the like. In the present invention, a DLC film and a moisture and gas barrier DLC film are distinct. By forming this moisture and gas barrier DLC film on the plastic surfaces, it is possible to improve the moisture and gas barrier properties of the plastic. In the present invention, a moisture and gas barrier DLC film is defined as a DLC film which can improve the moisture and gas barrier properties by three times or greater when comparing a plastic base material with the same plastic base material having a DLC film formed thereon. Further, the moisture and gas barrier properties depend on the thickness of the plastic base material. The present invention deals with the case where the plastic base material has a thickness of 300µm or greater. The case where the plastic base material has a thickness of 12 ∼ 300µm is called a plastic film. In particular, in the case of a film having a thickness of 12 ∼ 25µm, when the same moisture and gas barrier DLC film is formed, a ten times or greater improvement of the moisture and gas barrier properties can be expected.

It is a second object of the present invention to provide a moisture and gas barrier plastic container equipped with partition plates which has moisture and gas barrier properties in each compartment, instead of only the entire container, by using a moisture and gas barrier DLC film for the DLC film formed on the partition plate wall surfaces of the plastic container described above. The securing moisture and gas barrier properties for each compartment is especially beneficial in the case where the compartments are filled with different contents. Further, even in the case where the compartments are filled with the same contents, when the contents of each compartment are to be taken out separately, there is the benefit that it is possible to prevent the permeation of gases from the partition plates of the opened small compartments.

It is a third object of the present invention to provide an apparatus for manufacturing a DLC film coated plastic container, namely, a moisture and gas barrier plastic container equipped with partition plates in which a DLC film is formed by a plasma CVD method on the inner wall surfaces and the partition plate wall surfaces of the above-described plastic container equipped with partition plates. In the technology disclosed in Japanese Laid-Open Patent Publication No. HEI 8-53117, even if an attempt is made to form a DLC film on the inner wall surfaces and the partition plate wall surfaces of a container having a shape in which the inside of the container is partitioned into small compartments by partition plates, because there is only one internal electrode equipped with a source material blow out hole, the plasma is not generated uniformly inside each compartment, and as a result there is the risk that the film distribution will be nonuniform. As the result of earnest research conducted by the present inventors which should solve the specific problems of forming a DLC film in the case where the container is equipped with partition plates which form small compartments inside the container in this way, a uniform plasma was generated inside each compartment by giving the internal electrode a prescribed structure, and as a result it was possible to achieve a uniform film distribution on the inner wall surfaces and the partition plate wall surfaces. Further, in this case, uniform refers to the uniformity from the viewpoint of moisture and gas barrier properties.

It is a fourth object of the present invention to provide an apparatus for manufacturing a DLC film coated plastic container in which a DLC film is formed by a plasma CVD method on the inner wall surfaces and the partition plate wall surfaces of a plastic container equipped with partition plates, wherein the manufacturing apparatus stated in the third object is developed by supplying a high-frequency output and a microwave output simultaneously to the external electrode or the inside of the plastic container in order to provide a manufacturing apparatus which can form a finer film from the viewpoint of moisture and gas barrier properties at a faster rate.

It is a fifth object of the present invention to provide a manufacturing apparatus which can form a thicker DLC film on the partition plate wall surfaces than on the inner wall surfaces by providing one or more source gas blow out holes facing the partition plate wall surface side. Because a self-bias voltage is applied to the surface of the plastic base material at the film formation time, a fine DLC film from the viewpoint of moisture and gas barrier properties is formed at a fast rate on the inner wall surfaces. However, because this self-bias voltage is not applied to the surface of the partition plate wall surfaces, an inferior film from the viewpoint of moisture and gas barrier properties compared with such fine DLC film is easily formed. In this regard, in order to secure uniformity of the moisture and gas barrier at each wall surface, one or more source gas blow out holes facing the partition plate wall surfaces side are provided to form a thick DLC film on the partition plate wall surfaces to solve this problem.

It is a sixth object of the present invention to provide an apparatus for manufacturing a moisture and gas barrier plastic container equipped with partition plates in which a source gas plasma is generated uniformly inside the compartments by arranging a plurality of internal electrodes at prescribed spacings for insertion into the inside of each compartment inside the plastic container, whereby it becomes possible to achieve a uniform film distribution from the viewpoint of moisture and gas barrier properties.

It is a seventh object of the present invention to generate a source gas plasma more uniformly inside the compartments by connecting the plurality of internal electrodes with conductors provided therebetween in the manufacturing apparatus described above.

It is an eighth object of the present invention to generate a source gas plasma even more uniformly inside the compartments by forming the internal electrode to have a plate-shaped electrode structure in the manufacturing apparatus described above.

It is a ninth object of the present invention to provide a method of manufacturing a moisture and gas barrier plastic container equipped with partition plates in which a DLC film is formed by a plasma CVD method on the inner wall surfaces and the partition plate wall surfaces of a plastic container equipped with partition plates.

It is a tenth object of the present invention to provide a method of manufacturing a moisture and gas barrier plastic container equipped with partition plates which makes it possible to develop the manufacturing method stated in the ninth object, and form a finer DLC film from the viewpoint of moisture and gas barrier properties at a faster rate by a different film forming mechanism than that of the manufacturing method described above, namely, by supplying a high-frequency output and a microwave output simultaneously. In this manufacturing method, because a large thermal load is not applied to the plastic container which is the material receiving film formation, the generation of minute cracks in the film is inhibited, and this makes it possible to form a fine DLC film uniformly on the container inner wall surfaces at a high film formation rate.

It is an eleventh object of the present invention to provide a method of manufacturing a moisture and gas barrier plastic container equipped with partition plates in which moisture and gas barrier properties are also given to the partition plate wall surfaces of the plastic container in the method of manufacturing a moisture and gas barrier plastic container equipped with partition plates described above. The benefits of also giving moisture and gas barrier properties to the partition plate wall surfaces are the same as those described above.

It is a twelfth object of the present invention to provide a method of manufacturing a moisture and gas barrier plastic container equipped with partition plates, wherein the disadvantage that the film formed on the partition plate wall surfaces is inferior from the viewpoint of moisture and gas barrier properties is compensated by forming a thick film on the partition plate wall surfaces by making the amount of source gas supplied to the partition plate wall surfaces different from the amount of source gas supplied to the inner wall surfaces by a prescribed ratio, whereby uniformity of the moisture and gas barrier is secured at each compartment.

The solution means for achieving each of the objects described above are as follows.

In the moisture and gas barrier plastic container equipped with partition plates according to the present invention, a plastic container equipped with partition plates has a moisture and gas barrier DLC film formed on inner wall surfaces having an inside/outside relationship with respect to outer wall surfaces of said plastic container, and a DLC film formed on partition plate wall surfaces formed by said partition plates. Preferably, the DLC film formed on said partition plate wall surfaces is a moisture and gas barrier DLC film.

The apparatus for manufacturing a moisture and gas barrier plastic container equipped with partition plates according to the present invention is an apparatus for manufacturing a DLC film coated plastic container in which a DLC film is formed by a plasma CVD method on inner wall surfaces having an inside/outside relationship with respect to outer wall surfaces of a plastic container equipped with partition plates and partition plate wall surfaces formed by said partition plates, and is equipped with:
a vacuum chamber which surrounds said plastic container and also serves as an external electrode;
a grounded internal electrode which passes through said vacuum chamber and is inserted into the inside of each compartment inside said plastic container formed by said inner wall surfaces and said partition plate wall surfaces;
a high-frequency output supply means connected to said vacuum chamber to generate a source material plasma inside said plastic container; and
a source gas supply means which introduces a source gas into each compartment inside said plastic container.

Further, the apparatus for manufacturing a moisture and gas barrier plastic container equipped with partition plates is an apparatus for manufacturing a DLC film coated plastic container in which a DLC film is formed by a plasma CVD method on inner wall surfaces having an inside/outside relationship with respect to outer wall surfaces of a plastic container equipped with partition plates and partition plate wall surfaces formed by said partition plates, and is equipped with:
a vacuum chamber which surrounds said plastic container and also serves as an external electrode;
a grounded internal electrode which passes through said vacuum chamber and is inserted into the inside of each compartment inside said plastic container formed by said inner wall surfaces and said partition plate wall surfaces;
a microwave supply means which generates a source gas plasma inside said plastic container by introducing microwaves inside said plastic container;
a high-frequency output supply means which is connected to said vacuum chamber to generate a self-bias voltage at the inner wall surfaces of said plastic container in order to control the ionic incident energy of said source gas plasma for said inner wall surfaces or said partition plate wall surfaces; and
a source gas supply means which introduces a source gas into each compartment inside said plastic container.

The microwaves in the present invention refer to microwaves in the UHF range (300 ∼ 3000MHz), such as 2.45GHz microwaves, for example.

Further, in said manufacturing apparatus according to the present invention, said source gas supply means is preferably provided with one or more blow out supply holes of said source gas facing said partition plate wall surfaces.

Further, in said manufacturing apparatus according to the present invention, said internal electrode inserted into the inside of each compartment inside said plastic container preferably has a plurality of said internal electrodes arranged at prescribed spacings so as to generate said source gas plasma uniformly inside said compartments. In this case, conductors are preferably provided between said plurality of internal electrodes.

Further, in said manufacturing apparatus according to the present invention, said internal electrode inserted into the inside of each compartment inside said plastic container is preferably formed to have a plate-shaped electrode structure so as to generate said source gas plasma uniformly inside said compartments.

The method of manufacturing a moisture and gas barrier plastic container equipped with partition plates according to the present invention is a method of manufacturing a DLC film coated plastic container in which a DLC film is formed by a plasma CVD method on inner wall surfaces having an inside/outside relationship with respect to outer wall surfaces of a plastic container equipped with partition plates and partition plate wall surfaces formed by said partition plates, and includes the steps of:
housing said plastic container inside a vacuum chamber which also serves as an external electrode so that the outer wall surfaces of said plastic container is roughly in contact with the inner wall surface of said vacuum chamber, and inserting a grounded internal electrode in an insulated state with respect to said vacuum chamber into the inside of each compartment inside said plastic container formed by said inner wall surfaces and said partition plate wall surfaces from the opening of said plastic container; and then
supplying a source gas into each of said compartments inside said plastic container; and
forming a moisture and gas barrier DLC film on said inner wall surfaces of said plastic container and forming a DLC film on said partition plate wall surfaces by supplying a high-frequency output to said vacuum chamber to generate said source gas plasma in each of said compartments.

Further, the method of manufacturing a moisture and gas barrier plastic container equipped with partition plates according to the present invention is a method of manufacturing a DLC film coated plastic container in which a DLC film is formed by a plasma CVD method on inner wall surfaces having an inside/outside relationship with respect to outer wall surfaces of a plastic container equipped with partition plates and partition plate wall surfaces formed by said partition plates, and includes the steps of:
housing said plastic container inside a vacuum chamber which also serves as an external electrode so that the outer wall surfaces of said plastic container are roughly in contact with the inner wall surface of said vacuum chamber, and inserting a grounded internal electrode in an insulated state with respect to said vacuum chamber into the inside of each compartment inside said plastic container formed by said inner wall surfaces and said partition plate wall surfaces from the opening of said plastic container; and then
supplying a source gas into each of said compartments inside said plastic container; and
forming a moisture and gas barrier DLC film on said inner wall surfaces and forming a DLC film on said partition plate wall surfaces by supplying microwaves inside said plastic container to generate said source gas plasma inside each of said compartments, and roughly simultaneously supplying a high-frequency output to said vacuum chamber to generate a self-bias voltage at said inner wall surfaces of said plastic container.

In the manufacturing method according to the present invention, the DLC film formed on said partition plate wall surfaces preferably has moisture and gas barrier properties.

Further, in the manufacturing method according to the present invention, the amount of said source gas supplied to said partition plate wall surfaces is preferably 2 ∼ 10 times the amount of said source gas supplied to said inner wall surfaces, and more preferably 3 ∼ 5 times.

In the present invention, the self-bias voltage generated at the inner wall surfaces of the plastic container can be positive or negative depending on the pressure inside the vacuum chamber and the surface area ratio of the internal electrode and the vacuum chamber which also serves as an external electrode, but a negative self-bias voltage is preferably applied to the inner wall surfaces.

### BRIEF DESCRIPTION OF THE DRAWINGS

Fig. 1 is a conceptual view showing an embodiment of an apparatus for manufacturing a DLC film coated plastic container according to the present invention.
Fig. 2 is a model cross-sectional view taken along the lines A-A' of Fig. 1, and is a view showing a plate-shaped internal electrode.
Fig. 3 is a model cross-sectional view taken along the lines A-A' of Fig. 1, and is a view showing the case where the internal electrode is formed as pipe-shaped rods as a second embodiment of a manufacturing apparatus.
Fig. 4 is a model cross-sectional view taken along the lines A-A' of Fig. 1, and is a view showing the case where conductors are provided between the tips of pipe-shaped rods which form the internal electrode as a third embodiment of a manufacturing apparatus.
Fig. 5 is a view showing the shape of a moisture and gas barrier plastic container equipped with partition plates according to the present invention.
Fig. 6 shows views of an embodiment of an internal electrode in the apparatus for manufacturing a DLC film coated plastic container according to the present invention, and shows views of an internal electrode structure having source gas supply holes provided therein for forming a thick DLC film on the partition plate wall surfaces. (a) shows the internal electrode structure for the inner wall surfaces side, and (b) shows the internal electrode structure for the partition plate wall surfaces side.
Fig. 7 is an embodiment of an apparatus for manufacturing a DLC film coated plastic container according to the present invention, and is a conceptual view showing the case where only a high-frequency output is supplied to the vacuum chamber as a plasma generating means.

A description of the reference characters in the drawings is as follows. 1, 51 are plastic containers, 2, 52 are container outer wall surfaces, 3, 53 are container inner wall surfaces, 4, 54 are partition plates, 5, 55 are partition plate wall surfaces, 6, 56 are vacuum chambers which also serve as external electrodes, 7, 57 are compartments inside the containers, 8, 58 are internal electrodes, 9, 59 are insulating bodies, 11 is a window (quartz window), 12, 13 are source material supply holes, 20 is a microwave supply means, 21 is a microwave generating unit, 22 is an isolator, 23, 32, 82 are impedance matchers (matching units), 24 is a mode converter, 25 is a waveguide, 30, 80 are high-frequency output supply means, 31, 81 are high-frequency power supplies, 40, 90 are source gas supply means, 41, 91 are source gas supplies, 42, 44, 46, 92, 94, 96 are vacuum valves, 43, 93 are mass flow controllers, 45, 95 are pipes, 47, 97 are vacuum pumps, 48, 98 are shield boxes, 50 is a conductor, and 100, 200 are apparatuses for manufacturing a DLC film coated plastic container.

### PREFERRED EMBODIMENTS OF THE INVENTION

A detailed description of the preferred embodiments of the present invention is given below, but the present invention should not be interpreted as being limited to these preferred embodiments and specific embodiments.

### First Embodiment: Embodiment which Supplies a High-Frequency Output and a Microwave Output

### Manufacturing Apparatus

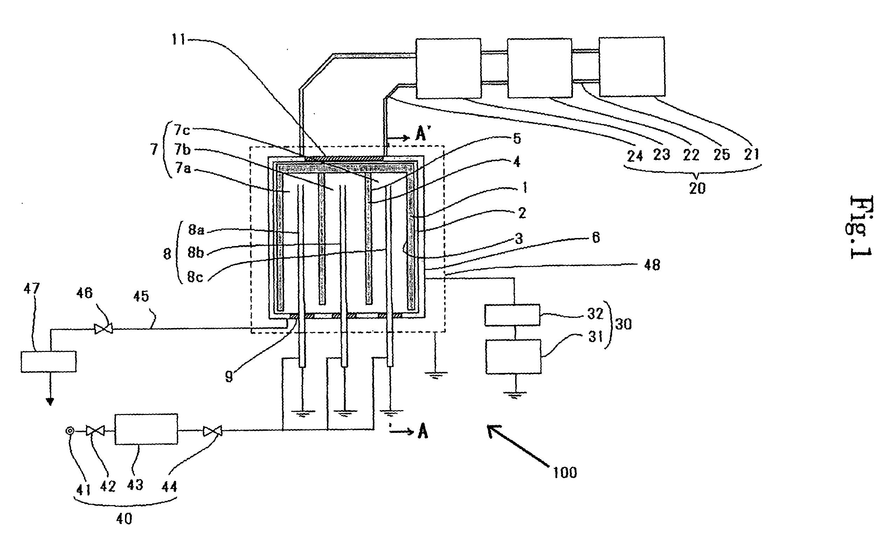

An embodiment of an apparatus for manufacturing a moisture and gas barrier plastic container equipped with partition plates according to the present invention will be described with reference to Fig. 1.

An apparatus 100 for manufacturing a moisture and gas barrier plastic container equipped with partition plates according to the present invention is an apparatus for manufacturing a DLC film coated plastic container which forms a DLC film by a plasma CVD method on inside wall surfaces 3 having an inside/outside relationship with respect to outer wall surfaces 2 of a plastic container 1 equipped with partition plates, and partition plate wall surfaces 5 formed by partition plates 4.

The apparatus 100 for manufacturing a moisture and gas barrier plastic container equipped with partition plates according to the present invention is equipped with a vacuum chamber 6 which surrounds the plastic container 1 and also serves as an external electrode, a grounded internal electrode 8 which is inserted into the inside of each compartment 7 inside the plastic container 1 formed by the inner wall surfaces 3 and the partition plate wall surfaces 5 via an insulating body 9 so as to form an insulated state with the vacuum chamber 6, a microwave supply means 20 which generates a source gas plasma inside the plastic container 1 by introducing microwaves inside the plastic container 1, a high-frequency output supply means 30 which is connected to the vacuum chamber 6 to generate a self-bias voltage at the inner wall surfaces 3 of the plastic container 1 in order to control the ionic incident energy of the source gas plasma for the inner wall surfaces 3, and a source gas supply means 40 which introduces a source gas into each compartment 7 inside the plastic container 1.

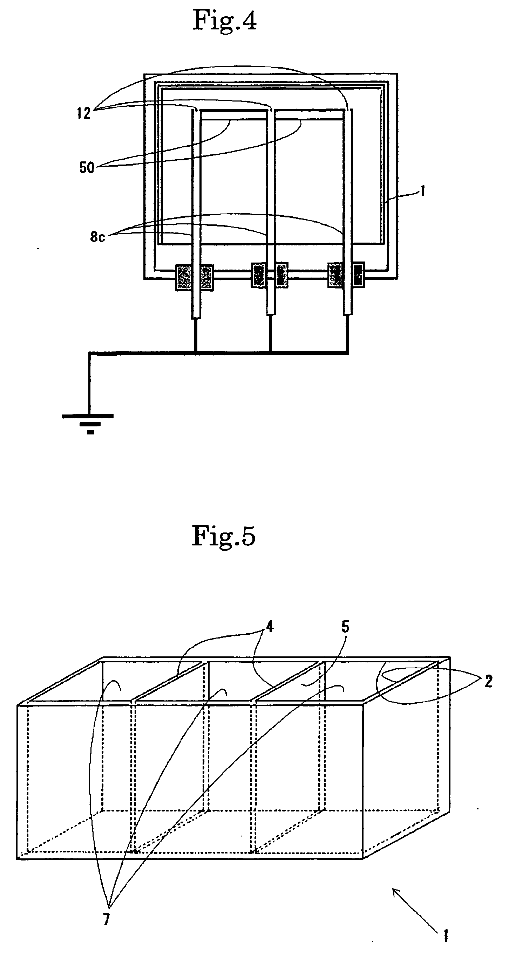

The plastic container 1 has the shape of a plastic container equipped with partition plates like that shown in Fig. 5. The plastic container includes other shapes in addition to the shape shown in Fig. 5, and there is no limit to the number of partition plates and the number of compartments partitioned by the partition plates. So long as partition plates are provided, the shape of the plastic container includes shapes in which an opening (hole portion) becomes narrow with respect to a body portion as in bottle shapes for beverages, and shapes in which the opening has the same or a slightly larger diameter with respect to the body portion as in tub shapes or beaker shapes. This includes containers having a stopper or a cover, and containers in which a sheet is sealed.

As for the material of the plastic container, polyethylene terephthalate resin (PET), polyethylene terephthalate type copolyester resin (a copolymer called PETG which uses cyclohexane demethanol in place of ethylene glycol in the alcohol component of polyester, produced by Eastman Chemical Company), polybutylene terephthalate resin, polyethylene naphthalate resin, polyethylene resin, polypropylene resin (PP), cycloolefin copolymer resin (COC, ring olefin copolymer), ionomer resin, poly-4-methylpentene-1 resin, polymethyl methacrylate resin, polystyrene resin, ethylene-vinyl alcohol copolymer resin, acrylonitrile resin, polyvinyl chloride resin, polyvinylidene chloride resin, polyamide resin, polyamide imide resin, polyacetal resin, polycarbonate resin, polysulfone resin, or ethylene tetrafluoride resin, acrylonitrile-styrene resin, acrylonitrile-butadiene-styrene resin are good, but PET, PETG, PP or COC is preferred because superior properties are exhibited. In the present embodiment, a container made of PETG, COC or PP is used.

The vacuum chamber 6 also serves as an external electrode, and has a sealing capability. The plastic container 1 is housed so that the inner wall surfaces of the vacuum chamber 6 almost make contact with the outer wall surfaces of the plastic container 1. Namely, the external shape of the plastic container 1 and the internal shape of the vacuum chamber 6 have similar shapes. Preferably, there is contact over the entire outer wall surfaces of the plastic container 1, but there may be separation so long as the outer wall surfaces and the inner wall surfaces of the vacuum chamber 6 are not separated locally.

The vacuum chamber 6 also servers as an external electrode, and forms an electrode which forms a pair with the internal electrode 8. Further, in order to introduce microwaves inside the vacuum chamber 6 from the microwave supply means 20, and in order to decrease the pressure inside the chamber at the time microwaves are introduced, a window 11 is provided at the connection portion of the microwave supply means 20 and the vacuum chamber 6. The material of the window 44 is a microwave permeable material (a material having a low dielectric constant), and is preferably quartz glass. The window 11 of Fig. 1 is provided at the place corresponding to the container bottom surface of the vacuum chamber 6, but the window 11 is not limited to this position. For example, the window 11 may be provided at a place corresponding to the opening of the plastic container 1. In the case where the window 11 is provided at a place corresponding to the opening, it is possible to also apply a self-bias voltage at the bottom portion of the plastic container 1. Further, the vacuum chamber 6 is equipped with an open/close mechanism (not shown in the drawings) which makes it possible to take out or put in the plastic container 1.

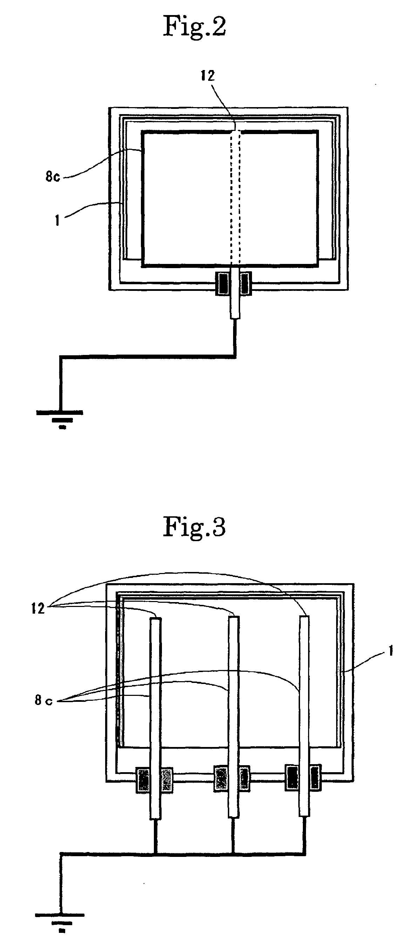

The structure of the internal electrode 8 has plate shapes, for example, and is equipped with supply holes 12 for introducing a source gas. The internal electrode 8 of the present embodiment internally houses the pipes of the source gas supply means 40, and also serves as a source gas supply means. As for the plates of the internal electrode 8, the number of plates of the internal electrode 8 is the same as the number of compartments 7 to make it possible to insert a plate into each compartment 7. The internal electrode 8 is inserted into the opening of each compartment 7 of the plastic container 1 via the insulated body 9 so as to form an insulated state with the vacuum chamber 6. The internal electrode 8 is grounded to have a ground potential. The shape of the plates forms a shape which follows the shape of each compartment 7 like that shown in Fig. 1 or Fig. 2, but the size, position and arrangement of the plates can be appropriately changed within a range in which the source gas plasma is generated uniformly inside each compartment 7 of the plastic container 1.

The structure of the internal electrode may be a structure in which a plurality of pipe-shaped rods are arranged at prescribed spacings like that shown in Fig. 3 (in the case of Fig. 3, three pipe-shaped rods are inserted inside each compartment). The reason for pipes is that by flowing a source gas inside the pipes, the openings of the tips of the pipe-shaped rods can be made to serve as gas supply holes. Namely, the internal electrode also serves as pipes for introducing a source gas. By forming a structure in which a plurality of pipe-shaped rods are arranged at prescribed spacings, it becomes possible to uniformly generate a source gas plasma inside each compartment. The number of pipe-shaped rods inside each compartment, and the spacings and arrangement thereof can be appropriately changed within a range in which the source gas plasma is generated uniformly inside each compartment.

Further, the structure of the internal electrode may be an internal electrode structure in which conductors 50 are provided between the tips of the pipe-shaped rods which form the internal electrode (in the case of Fig. 4, three pipe-shaped rods are inserted inside each compartment, and the conductors 50 are provided between these). The internal electrode of Fig. 4 also serves as pipes for introducing a source gas. By forming a structure in which a plurality of pipe-shaped rods are arranged at prescribed spacings, and the conductors 50 are provided between the tips thereof, it becomes possible to more uniformly generate a source gas plasma inside each compartment. The number of pipe-shaped rods inside each compartment, and the spacings and arrangement thereof can be appropriately changed within a range in which the source gas plasma is generated uniformly inside each compartment in the same way as in the case of Fig. 3.

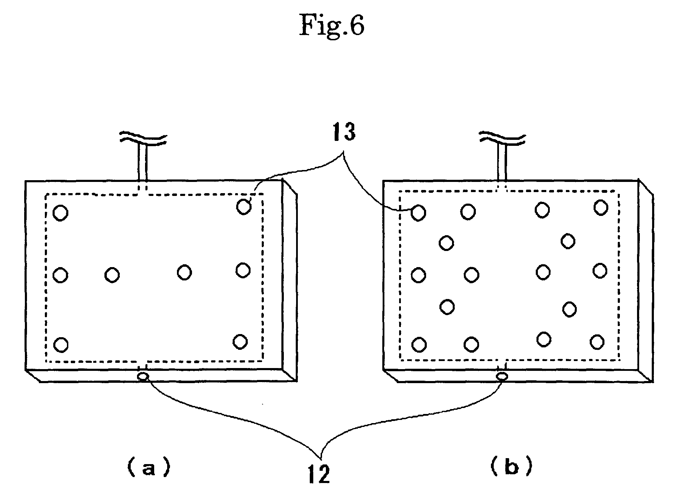

Further, in the case where a thick DLC film is formed on the partition plate wall surfaces of each compartment 7, supply holes 13 which face the partition plate wall surfaces and introduce a source gas are provided in addition to the supply holes 12 as shown in Fig. 6, and adjustments are carried out so that more source gas is supplied to the partition plate wall surfaces than to the inner wall surfaces of the plastic container 1. Further, source gas supply holes may be provided at the inner wall surfaces side. In this case, the number of supply holes facing the partition plate wall surfaces is greater than the number of source gas supply holes facing the inner wall surfaces side. The reason for forming a thick DLC film on the partition plate wall surfaces of each compartment 7 is as follows. At the film formation time, because a self-bias voltage is applied at the plastic base material surface of the inner wall surface portions, a fine DLC film from the viewpoint of moisture and gas barrier properties is formed at a fast rate. However, because this self-bias voltage is not applied to the partition plate wall surfaces, an inferior film from the viewpoint of moisture and gas barrier properties compared with such fine DLC film is easily formed. In this regard, in order to secure uniformity of the moisture and gas barrier at each wall surface, one or more source gas blow out holes facing the partition plate wall surfaces side are provided to form a thick DLC film on the partition plate wall surfaces to secure moisture and gas barrier properties.

The insulating body 9 insulates the internal electrode 8 and the vacuum chamber 6. Any shape and material may be used so long as this function is achieved. For example, a sintered plate of alumina represents an example.

The microwave supply means 20 generates a source gas plasma inside the plastic container 1 by introducing microwaves inside the plastic container 1. As shown in Fig. 1, the microwave supply means 20 is constructed from a microwave generating unit 21 which generates microwaves (e.g., 2.45GHz), an isolator 22, an impedance matcher 23 and a mode converter 24. Each of the microwave generating unit 21, the isolator 22 and the impedance matcher 23 is connected via a waveguide 25 which passes microwaves. The structure of the microwave supply means 20 is not limited to the structure shown in Fig. 1, and any structure may be used so long as it is possible to introduce microwaves inside the plastic container 1 with good efficiency.

The high-frequency output supply means 30 is constructed from a high-frequency power supply 31 and an impedance matcher 32 as shown in Fig. 1. A high-frequency power supply (RF power supply, 13.56MHz) 12 is connected to the impedance matcher 32 via a coaxial cable, and connected to the vacuum chamber 6. Further, the ground side of the output terminal of the high-frequency power supply 12 is grounded. By supplying high-frequency waves to the vacuum chamber 6, a self-bias voltage is generated at the plastic container inner wall surfaces positioned at the vacuum chamber surface.

The source gas supply means 40 introduces a source gas to the inside of the plastic container 1. One side of a vacuum valve 42 is connected to the output side of a source gas supply 41, a flow meter (mass flow controller) 43 for adjusting the source gas flow rate is connected to the other side of the vacuum valve 42, one side of a vacuum valve 44 is connected to the other side of the flow meter 43, and the internal electrode 8 is connected to the other side of the vacuum valve 44. The internal electrode has pipe shapes, and the source gas supply holes 12 are provided in the tips thereof, whereby a source gas is blown out from the source gas supply holes 12. The source gas supply means 40 may be given a structure different than that described above so long as it is possible to supply a source gas at a prescribed flow rate inside the plastic container 1. Further, the source gas may also be blown out from the source gas supply holes 13.

Aliphatic hydrocarbons, aromatic hydrocarbons, hydrocarbons containing oxygen, hydrocarbons containing nitrogen and the like which are a gas or a liquid at normal temperature are used as the source gas. In particular, benzene, toluene, 0-xylene, m-xylene, p-xylene, cyclohexane and the like which have a carbon number of 6 or higher are preferred. In the case of use in a container of food and the like, from the viewpoint of hygiene, aliphatic hydrocarbons, namely, ethylene hydrocarbons such as ethylene, propylene or butylene or the like, or acetylene hydrocarbons such as acetylene, allyrene or 1-butyne or the like are preferred. These source materials may be used individually, or a mixed gas of two or more kinds may be used. Further, these gases may be used in a form where they are diluted by an noble gas such as argon or helium.

Further, in the case where a DLC film containing silicon is formed, a hydrocarbon gas containing Si is used.

The space inside the vacuum chamber 6 is connected to one side of a pipe 45, and the other side of the pipe 45 is connected to a vacuum pump 47 via a vacuum valve 46. The vacuum pump 47 is connected to the exhaust side.

In the apparatus 100 for manufacturing a moisture and gas barrier plastic container equipped with partition plates according to the present invention, the entire vacuum chamber 6 is covered by a shield box 48. This prevents high-frequency waves from leaking to the outside.

The present invention is not limited to the embodiment described above, and various changes can be made thereto. For example, in the present embodiment, a description was given in accordance with an apparatus for one plastic container, but by providing a plurality of these units, it is possible to construct a film forming apparatus which makes it possible to simultaneously coat a plurality of plastic containers.

In the present embodiment, the container having a thin film formed on the inner wall surface is primarily used as a food container such as a lunch box or the like, or a beverage container, and an ink cartridge for a recording printer having an ink jet recording system, a container for a simple analysis set and the like can be made other examples, but there is no limit to the applications.

In the present embodiment, a DLC film or a DLC film containing Si is used as the thin film formed by the CVD film forming apparatus, but the film forming apparatus described above can also be used when forming other thin films inside the container.

In the first embodiment, the present inventors effectively combined the high-frequency capacitive coupling type discharge system and the microwave discharge system, and discovered a film forming mechanism for forming a high-quality film with good productivity which is different than the film forming mechanism of each method, whereby the present invention was achieved.

In general, in a high-frequency capacitive coupling type discharge system, the plasma density can not be raised after the plasma density reaches 10⁹ cm⁻³, and the control of the plasma density and the control of the ionization energy can not be carried out independently. When the high-frequency waves are given a high output in order to raise the plasma density, many ionic collisions are created, and the etching effect is increased. Accordingly, in a high-frequency capacitive coupling type discharge system, the film forming rate can not be speeded up. For this reason, in the case where a DLC film is coated on a large amount of container in a short time, the productive efficiency needs to be raised by separate means. Further, a self-bias voltage is generated on the container inner wall surfaces, and this causes the source material converted to a plasma to be attracted to the plastic container wall surfaces, whereby ionic collisions occur. On the other hand with regard to obtaining a relatively fine DLC film, because the control of the ionization energy can not be carried out properly, there is a large number of ionic collisions, and this raises the temperature of the plastic and generates internal stress due to differential thermal expansion, whereby fine cracks are created. These fine cracks lower the moisture and gas barrier properties, and this causes the occurrence of film peeling due to washing of the plastic container.

On the other hand, in a microwave discharge system, because the plasma density can reach a high density of 10¹¹ ∼ 10¹² cm⁻³, a high-density ionized source material can be supplied to the plastic surface, and this makes it possible to speed up the film forming rate. However, because a self-bias voltage is not generated at the plastic container inner wall surfaces, the ionized material is not attracted to the plastic surface, and because ionic collisions do not occur, it is difficult to obtain a fine DLC film. Accordingly, the moisture and gas barrier properties are believed to be lower than those of the DLC film formed in the high-frequency capacitive coupling type discharge system. Further, the film thickness needs to be made large in order to secure the same moisture and gas barrier properties.

The film forming mechanism invented by the present inventors is a mechanism for forming a DLC film in which the ions created by the plasma generated by microwaves are forcibly attracted to the outer wall surfaces or the inner wall surfaces of the plastic container by the self-bias caused by high-frequency waves. This film formation method makes it possible to form a DLC film uniformly on the intended wall surfaces of a plastic container, prevents the creation of minute cracks in the film with no severe thermal load on the plastic container which is the material receiving film formation, and makes it possible to form a fine DLC film at a high film forming rate.

Instead of a viewpoint referring to a large density, the fine DLC film mentioned in the present invention means a DLC film having a small product of the solubility coefficient of vapor molecules of oxygen, hydrogen, carbon dioxide, nitrogen or organic molecules or the like to the inside of the film and the dispersion coefficient of the vapor molecules.

Further, the moisture and gas barrier properties mentioned in the present invention are properties determined by the product of the solubility coefficient of the vapor molecules to the inside of the film and the dispersion coefficient of the vapor molecules described above (the fineness), the amount of minute cracks in the film and the film thickness. From the viewpoint of the moisture and gas barrier properties, an ideal DLC film satisfies the conditions of being fine, having a small amount of film cracks and having a film thickness within a prescribed film thickness range. When the film is fine and has a small amount of cracks, the required film thickness can be made small. Further, in general if the film thickness is too small, the entire surface of the plastic can not be covered, and if the film thickness is too large, the internal stress of the film will become large, and it becomes impossible to follow the flexibility of the plastic. In the present invention, the film thickness of the DLC film is 30 ∼ 5000Å, and preferably 200 ∼ 3000Å.

Further, in the manufacturing apparatus described above, the high-frequency output supply means not only generates a self-bias but also obtains plasma generation, but the plasma generation of the high-frequency output supply means can not be anything more than just an auxiliary means of the microwave output supply means which is the plasma generating means. Even in the manufacturing method, the plasma generation due to the high-frequency output supply is an auxiliary generation. Further, instead of being separated from the plasma, the inner wall surfaces or the outer wall surfaces of the plastic container are preferably in contact with the plasma generating space.

### Manufacturing Method

Next, a description will be given for the method of manufacturing a moisture and gas barrier plastic container equipped with partition plates using the apparatus 100 for manufacturing a DLC film coated plastic container shown in Fig. 1.

First, a vacuum valve (not shown in the drawings) is opened to open the inside of the vacuum chamber 6 to the atmosphere. In this way, air flows in, and the inside of the vacuum chamber 6 reaches atmospheric pressure. Next, the vacuum chamber is opened by an open/close mechanism (not shown in the drawings) of the vacuum chamber 6, and a plastic container 1 is provided by being housed inside the vacuum chamber in a direction where the bottom portion thereof makes contact with the quartz window 11. At this time, the inner surface of the vacuum chamber 6 and the outer wall surfaces of the plastic container 1 form a rough contacting state. Next, the vacuum chamber is closed and sealed by the open/close mechanism (not shown in the drawings) of the vacuum chamber 6. Each plate of the internal electrode 8 is in an inserted state inside each compartment 7 through the opening of the plastic container 1.

Then, after the vacuum valve (not shown in the drawings) is closed, the vacuum valve 46 is opened, and air is exhausted by the vacuum pump 47. In this way, the inside of the plastic container 1 is exhausted through the pipe 45 to lower the pressure inside the plastic container 1. At this time, the pressure inside the plastic container 1 is 5 × 10⁻³ ∼ 5 × 10⁻² Torr.

Next, the vacuum valve 42 is opened, a hydrocarbon gas is generated in a source gas supply 41, this hydrocarbon gas is introduced inside a pipe, and then the hydrocarbon gas having a controlled flow rate by a flow meter 43 is blown out inside the plastic container 1 from the supply holes 12 of the internal electrode via a vacuum valve 44. In this way, a hydrocarbon gas is introduced inside the plastic container 1.

At this time, in the case where a thick DLC film is formed on the partition plate wall surfaces of each compartment 8, the source gas is supplied toward the partition plate wall surfaces from the supply holes 13 in addition to the supply holes 12, and adjustments are carried out so that more source gas is supplied to the partition plate wall surfaces than to the inner wall surfaces of the plastic container 1. The amounts of supplied source gas may be adjusted separately by providing separate source gas systems for the supply holes of the inner wall surfaces and the supply holes of the partition plate wall surfaces. The amount of source gas supplied to the partition plate wall surfaces is 2 ∼ 10 times the amount of source gas supplied to the inner wall surfaces, and preferably 3 ∼ 5 times.

Then, by balancing the controlled gas flow rate and the exhaust capacity, a pressure (e.g., about 0.05 ∼ 0.50Torr) suited to DLC film formation is maintained inside the plastic container 1.

Then, microwaves (e.g., 2.45GHz) at 50 ∼ 1000W are supplied to the inside of the plastic container 1 by the microwave supply means 20. This microwave output value is an example, and adjustments are carried out in accordance with the size of the vacuum chamber and the container. The impedance is adjusted so that the output is supplied inside the chamber with good efficiency. A source gas plasma is generated inside the plastic container 1, namely, inside each compartment 7 by the supplied microwaves. The density of the plasma can be made 10¹¹ ∼ 10¹² cm⁻³.

At the same time or roughly the same time as the microwave supplying described above, a high-frequency output (e.g., 13.56MHz) at 10 ∼ 1000W is supplied to the vacuum chamber 6 from the high-frequency power supply 31 via the matching unit 32. At this time, the matching unit 32 matches the impedance of the internal electrode 8 and the vacuum chamber 6 by the inductance L and the capacitance C. A self-bias voltage is generated at the plastic container inner wall surfaces by the high-frequency waves supplied to the vacuum chamber 6. Positively charged ions from the source gas plasma generated inside each compartment 7 by the microwaves are attracted to the vacuum chamber 6 side, namely, the inner wall surfaces side of the plastic container. In this way, the positively charged ions collide with the inner wall surfaces of the plastic container 1 and form a DLC film. Further, even though a self-bias voltage is not applied to the partition plate wall surfaces, a DLC film is formed in the same way. Because more source gas is supplied to the partition plate wall surfaces, the thickness of the DLC film is large when compared with the DLC film formed on the inner wall surfaces. The film formation time at this time is around several seconds which is short.

A fine DLC film having moisture and gas barrier properties is formed at a fast rate on the inner wall surfaces of the plastic container 1. On the other hand, a DLC film which does not have the degree of fineness of the DLC film formed on the inner wall surfaces is formed on the partition plate wall surfaces. The DLC film formed on the inner wall surfaces has moisture and gas barrier properties, and on the other hand, the DLC film formed on the partition plate wall surfaces has moisture and gas barrier properties by carefully adjusting the film thickness.

Further, the high-frequency output value described above is an example, and adjustments are carried out in accordance with the size and the like of the vacuum chamber and the container, and in particular the value is adjusted for the purpose of adjusting the self-bias. This adjustment is for forming a DLC film having a desired fineness in accordance with the container.

The microwave supply rate and the high-frequency output are controlled independently. The film forming mechanism in the present manufacturing method is a mechanism for forming a DLC film in which the ions created by the plasma generated by microwaves are forcibly attracted to the inner wall surfaces of the plastic container by the self-bias caused by the high-frequency output, and this is different from the single system of the high-frequency capacitive coupling type discharge system or the microwave discharge system. Further, the DLC film obtained by the present invention is a higher quality film than that made by the single systems described above from the viewpoint of water and gas barrier properties, and film formation can be carried out with good productivity.

Next, the high-frequency output from the high-frequency power supply 31 is stopped, and at the same time the microwave output from the microwave generating unit 21 is also stopped. The vacuum valves 42, 44 are closed and the supply of the source gas is stopped. Then, the vacuum valve 46 is opened, and the hydrocarbon gas remaining in the plastic container 1 is exhausted by the vacuum pump 47. Then, the vacuum valve 46 is closed, and the vacuum pump 47 is stopped. In the case where a film is to be formed on the next plastic container, the vacuum pump 47 is kept in an operating state without being stopped. The pressure inside the vacuum chamber 6 at this time is 5 × 10⁻³ ∼ 5 × 10⁻²Torr.

Then, a vacuum valve (not shown in the drawings) is opened to open the inside of the vacuum chamber 6 to the atmosphere, and by repeatedly carrying out the manufacturing method described above, a DLC film is formed on the inner wall surfaces of the next plastic container.

### Second Embodiment: Embodiment which Supplies a High-Frequency Output

### Manufacturing Apparatus

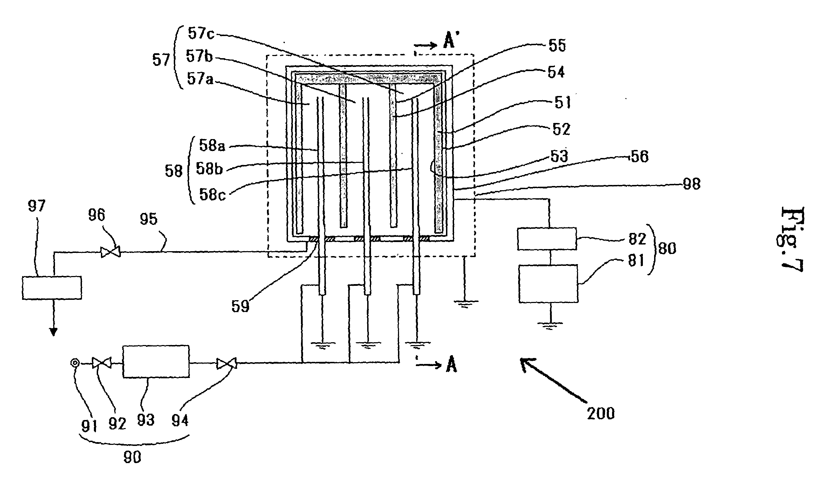

An embodiment of an apparatus for manufacturing a moisture and gas barrier plastic container equipped with partition plates according to the present invention will be described with reference to Fig. 7.

An apparatus 200 for manufacturing a moisture and gas barrier plastic container equipped with partition plates according to the present invention is a type of apparatus in which only a high-frequency output serving as a plasma generating means is supplied to the vacuum chamber. The manufacturing apparatus 200 has the same function as the case where the microwave supply means is not operated in the apparatus 100 for manufacturing a moisture and gas barrier plastic container equipped with partition plates according to the present invention.

The plate shapes of the internal electrode are the same as those in the first embodiment. However, the difference is that a microwave output serving as a plasma generating means is not supplied, and a plasma is generated by supplying a high-frequency output. Further, in the second embodiment, there is also the point of difference that the high-frequency output can not be controlled independently from the generation of the bias voltage.

The apparatus 200 for manufacturing a moisture and gas barrier plastic container equipped with partition plates according to the present invention is equipped with a vacuum chamber 56 which surrounds a plastic container 51 and also serves as an external electrode, a grounded internal electrode 58 which is inserted into the inside of each compartment 57 inside the plastic container 51 formed by inner wall surfaces 53 and partition plate wall surfaces 55 via an insulating body 59 so as to form an insulated state with the vacuum chamber 56, a high-frequency output supply means 80 which is connected to the vacuum chamber 56 to generate a source gas plasma, and a source gas supply means 90 which introduces a source gas into each compartment 57 inside the plastic container 51.

The plastic container, the insulating body, the source gas supply means, the kinds of source gas, the exhaust structure of the space inside the external electrode and the shield box are the same as those of the first embodiment.

There is no need to provide a window 61 for microwave introduction in the vacuum chamber 56.

The internal electrode 58 can use the same electrode structures as those of the first embodiment shown in Fig. 1 and Fig. 2 ∼ Fig. 4. Further, in the case where a thick DLC film is formed on the partition plate wall surfaces of each compartment 57, it is possible to use a structure having the same supply holes 13 shown in Fig. 6.

The high-frequency output supply means 80 is the same as that shown in the first embodiment, and even though it is possible to supply energy for generating a source gas plasma, and generate a self-bias voltage at the inner wall surfaces of a PET bottle by the plasma generated between the internal electrode and the PET bottle inner wall surfaces positioned at the external electrode surface, it is not possible to freely control the self-bias level.

### Manufacturing Method

This method is the same as that of the first embodiment, but the operation at the source gas plasma generation time is different. Namely, without supplying microwaves, only a high-frequency output (e.g., 13.56MHz) at 10 ∼ 1000W is supplied to the vacuum chamber 56. At this time, a source gas plasma is generated inside each compartment 57 of the plastic container 51. Further, a self-bias voltage is generated at the plastic container inner wall surfaces by the high-frequency waves supplied to the vacuum chamber 56. Positively charged ions from the generated source gas plasma are attracted to the vacuum chamber 56 side, namely, the inner wall surfaces side of the plastic container. In this way, the positively charged ions collide with the inner wall surfaces of the plastic container 51 and form a DLC film. The film formation time at this time is around several seconds which is short. The difference with the first embodiment is that the plasma generation density and the bias voltage which imparts ionic incident energy can not be controlled independently. However, the plasma generation described in the second embodiment also makes it possible to provide a method of manufacturing a moisture and gas barrier plastic container equipped with partition plates having moisture and gas barrier properties.

### SPECIFIC EMBODIMENTS

Specific embodiments of the case where moisture and gas barrier properties are imparted to a plastic container equipped with partition plates by the manufacturing apparatus and the manufacturing method described in the first embodiment are given below.

### Specific Embodiment 1

A DLC film was formed on the inner wall surfaces and the partition plate wall surfaces of a plastic container equipped with partition plates using the manufacturing apparatus of Fig. 1 and Fig. 2 described in the first embodiment, and then evaluations were carried out.

The plastic container used a container equipped with partition plates (Fig. 5, two partition plates, capacity 2000ml, 10cm × 20cm × 10cmH, resin thickness 2mm, inner wall surface area 800cm², surface area of one surface of partition plate wall surfaces 100cm²). The container material was PETG. The source gas used acetylene. The film forming pressure inside the vacuum chamber was 0.10Torr, the source gas flow rate was 1200sccm, the film formation time was 2 seconds, the high-frequency output was 500W, and the microwave output was 500W. The position, direction and number of the source gas supply holes was adjusted so that the amount of source gas supplied to the inner wall surfaces side 1 of the plastic container formed a proportion of the amount of source gas supplied to the partition plate wall surfaces side 5. The plasma CVD conditions are shown in Table 1. Further, a DLC film was formed on both sides of the partition plate wall surfaces.

### Specific Embodiments 2 ∼ 10

Each of Specific Embodiments 2 ∼ 10 was made by changing one part of the conditions for Specific Embodiment 1, and forming a DLC film on the inner wall surfaces and the partition plate wall surfaces of a plastic container equipped with partition plates. The film forming conditions of each specific embodiment form the conditions stated in Table 1.

Further, Specific Embodiment 4 is a specific embodiment in which microwaves are not introduced, and this corresponds to the second embodiment. Further, Specific Embodiment 6 is an example in which the high-frequency output is the main output and the microwave output is an auxiliary output when plasma is generated, and has conditions in which microwaves are introduced supplementally to raise the plasma density in order to compensate for the defect in the high-frequency capacitive coupling type discharge system which has a small plasma density.

### Comparative Example 1

The case where a DLC film is not formed was made Comparative Example 1. The container was made of PETG.

### Comparative Example 2

The case where a DLC film is not formed was made Comparative Example 2. The container was made of PP.

### Comparative Example 3

The case where a DLC film is not formed was made Comparative Example 3. The container was made of COC.

### Comparative Example 4

Except for the film formation time being 0.5 seconds, Comparative Example 4 was made the same way as Specific Embodiment 1.

**TABLE 1**

| | Film Forming Pressure Inside Vacuum Chamber (Torr) | Source Gas Flow Rate (sccm) | Container Material | Film Formation Time (s) | Supply Ratio of Amount of Supplied Source Gas (Inner Wall Surfaces Side/Partition Plate Wall Surfaces Side) | High-Frequency Output (W) | Microwave Output (W) |
|---|---|---|---|---|---|---|---|
| Specific Embodiment1 | 0.10 | 1200 | PETG | 2 | 1/5 | 500 | 500 |
| Specific Embodiment2 | 0.10 | 600 | PETG | 2 | 1/2 | 500 | 500 |
| Specific Embodiment3 | 0.10 | 2000 | PETG | 2 | 1/10 | 500 | 500 |
| Specific Embodiment4 | 0.10 | 300 | PETG | 6 | 1/5 | 1000 | 0 |
| Specific Embodiment5 | 0.10 | 1200 | PETG | 2 | 1/5 | 350 | 600 |
| Specific Embodiment6 | 0.10 | 1200 | PETG | 2 | 1/5 | 600 | 250 |
| Specific Embodiment7 | 0.10 | 1200 | PP | 2 | 1/5 | 500 | 500 |
| Specific Embodiment8 | 0.10 | 1200 | COC | 2 | 1/5 | 500 | 500 |
| Specific Embodiment9 | 0.10 | 400 | PETG | 2 | 1/1 | 500 | 500 |
| Specific Embodiment10 | 0.10 | 2400 | PETG | 2 | 1/13 | 500 | 500 |
| Comparative Example1 | ― | ― | PETG | ― | ― | ― | ― |
| Comparative Example2 | ― | ― | PP | ― | ― | ― | ― |
| Comparative Example3 | ― | ― | COC | ― | ― | ― | ― |
| Comparative Example4 | 0.10 | 1200 | PETG | 0.5 | 1/5 | 500 | 500 |

The following evaluations were carried out for the containers of Specific Embodiments 1 ∼ 10 and Comparative Examples 1 ∼ 4.

### (1) Distribution of DLC Film

The thickness of the DLC film was measured by Tenchol Company's alpha-step500 tracer type difference meter. The film thickness was measured at each of three points of a side surface of the container inner wall surfaces, the bottom surface of the container inner wall surfaces, and the partition plate wall surfaces, and an average value was calculated to give the film thickness at each surface.

### (2) Presence/Absence of Deformation of Container

The case where the container is visually observed to have a deformation is represented by ×, and the case where there is no deformation is represented by ○.

### (3) Film Formation Rate

The film formation rate was calculated by dividing the film thickness at the side surface of the container inner wall surfaces calculated in (1) by the film formation time. Further, it is possible to calculate the film thickness at other surfaces in the same way.

### (4) Oxygen Permeability

Measurements were made using an Oxtran manufactured by Modem Control Company under the conditions 22°C × 60% RH. The oxygen permeability (oxygen permeating through the inner wall surfaces) at the inside and outside was measured for the entire container.

### (5) Moisture Permeability

The moisture permeability (moisture permeating through the inner wall surfaces) at the inside and outside was measured for the entire container. As for the moisture permeability of the container, calcium chloride was filled into each compartment of the container, the cover was sealed by a stainless steel plate, and then this was kept under the conditions 40°C × 90% RH. With the passing of time, the calcium chloride absorbs moisture and changes weight. The moisture permeability was evaluated by measuring this change in weight. Further, the partition plates were cut out, and then the moisture permeability of the partition plates was calculated as an indicator of the moisture permeability between each compartment. This was measured using an Oxtran manufactured by Modem Control Company under the conditions 40°C × 90% RH.

The evaluation results are shown in Table 2.

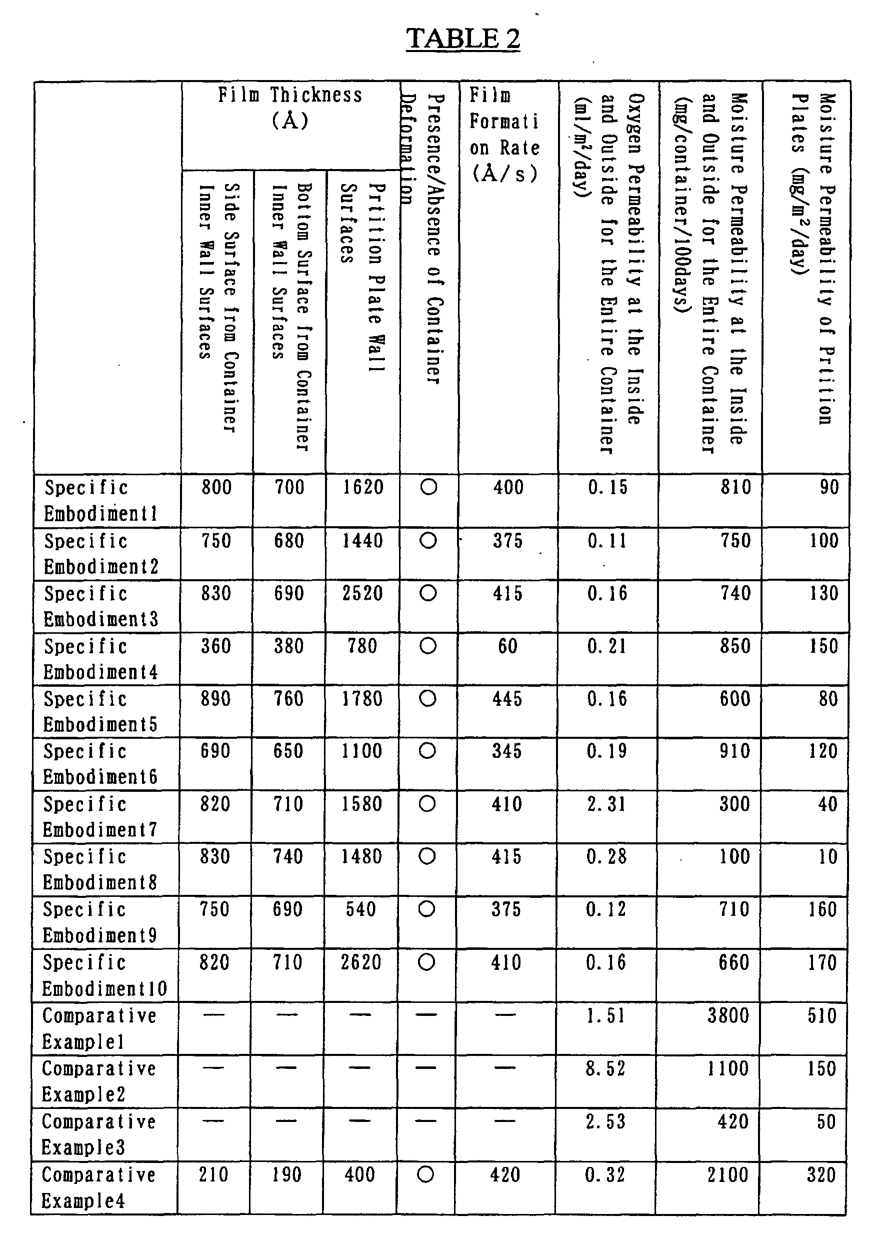

In Specific Embodiments 1 ∼ 3, by supplying a high-frequency output and a microwave output simultaneously, and adjusting the supply ratio (inner wall surfaces side / partition plate wall surfaces side) of the amount of supplied source gas, it was possible to provide a plastic container equipped with partition plates in which both the oxygen permeability and the moisture permeability was low. Compared with Comparative Example 1, in Specific Embodiment 1, it was discovered that the oxygen permeability for the entire container was improved 10.1 times, and the moisture permeability was improved 4.7 times. Further, it was discovered that the moisture permeability of each compartment was improved 5.7 times. In Specific Embodiment 2, it was discovered that the oxygen permeability for the entire container was improved 13.7 times, and the moisture permeability was improved 5.1 times. Further, it was discovered that the moisture permeability of each compartment was improved 5.1 times. In Specific Embodiment 3, it was discovered that the oxygen permeability for the entire container was improved 9.4 times, and the moisture permeability was improved 5.1 times. Further, it was discovered that the moisture permeability of each compartment was improved 3.9 times. The film formation rate was relatively fast due to the effect of supplying a high-frequency output and a microwave output simultaneously. Further, because there is both the effect of microwave introduction and the effect of high-frequency wave introduction, a fine film is easily obtained with few cracks. However, in Specific Embodiments 1 ∼ 3, the high-frequency output is large, and because an etching effect appears, Specific Embodiment 1 has a slightly slow film formation rate compared with Specific Embodiment 5, for example.

In Specific Embodiment 9, the moisture permeability of the partition plates was improved 3.2 times when compared with Comparative Example 1, but was inferior compared with Specific Embodiments 1 ∼ 3. However, it was discovered that the oxygen permeability for the entire container was improved 12.6 times, and the moisture permeability was improved 5.4 times.

In Specific Embodiment 4, by supplying only a high-frequency output, and adjusting the supply ratio (inner wall surfaces side / partition plate wall surfaces side) of the amount of supplied source gas, it was possible to provide a plastic container equipped with partition plates in which both the oxygen permeability and the moisture permeability was low. Compared with Comparative Example 1, in Specific Embodiment 4, it was discovered that the oxygen permeability for the entire container was improved 7.2 times, and the moisture permeability was improved 4.5 times. Further, it was discovered that the moisture permeability of each compartment was improved 3.4 times. However, the film formation rate was slow compared with Specific Embodiments 1 ∼ 3.

In Specific Embodiments 5 ∼ 6, the output levels were adjusted when a high-frequency output and a microwave output were supplied simultaneously. In both the case where the microwave output is made the main output and the creation of a high density plasma is considered to be important (Specific Embodiment 5), and the case where the plasma generation effect due to microwaves is controlled while the high-frequency output is made the main output and the self-bias effect is made strong (Specific Embodiment 6), it was possible to provide a plastic container equipped with partition plates in which both the oxygen permeability and the moisture permeability was low. The film formation rate was relatively fast due to the effect of supplying a high-frequency output and a microwave output simultaneously. In Specific Embodiment 5, the film was formed very fast because the DLC film was formed by source ions of the high-density plasma being attracted by the self-bias voltage without much appearance of an etching effect. The DLC film was a fine film with few cracks. Although not as good as Specific Embodiment 5, the fineness was high and there were few minute cracks in Specific Embodiment 6.

Compared with Comparative Example 1, in Specific Embodiment 5, it was discovered that the oxygen permeability for the entire container was improved 9.4 times, and the moisture permeability was improved 6.3 times. Further, it was discovered that the moisture permeability of each compartment was improved 6.4 times. In the same way, compared with Comparative Example 1, in Specific Embodiment 6, it was discovered that the oxygen permeability for the entire container was improved 7.9 times, and the moisture permeability was improved 4.2 times. Further, it was discovered that the moisture permeability of each compartment was improved 4.3 times.

In Specific Embodiment 7, the material of the container was changed to PP, but this had no specific effect, and this embodiment was the same as Specific Embodiment 1. Compared with Comparative Example 2, in Specific Embodiment 7, it was discovered that the oxygen permeability for the entire container was improved 3.7 times, and the moisture permeability was improved 3.7 times. Further, it was discovered that the moisture permeability of each compartment was improved 3.8 times.

In Specific Embodiment 8, the material of the container was changed to COC, but this had no specific effect, and this embodiment was the same as Specific Embodiment 1. Compared with Comparative Example 3, in Specific Embodiment 8, it was discovered that the oxygen permeability for the entire container was improved 9.0 times, and the moisture permeability was improved 4.2 times. Further, it was discovered that the moisture permeability of each compartment was improved 5.0 times.

In Specific Embodiment 10, the supply ratio (inner wall surfaces side / partition plate wall surfaces side) of the amount of supplied source gas was small, and thickness of the DLC film formed on the partition plates was slightly large. Conversely, the thickness of the DLC film formed on the inner wall surfaces was slightly thin, but the entire container had moisture and gas barrier properties. Compared with Comparative Example 1, in Specific Embodiment 10, it was discovered that the oxygen permeability for the entire container was improved 9.4 times, and the moisture permeability was improved 5.8 times. Further, it was discovered that the moisture permeability of each compartment was improved 3.0 times.

In Comparative Example 4, the film thickness was small because the film formation time was short. When compared with Comparative Example 1, this example had gas barrier properties in which the oxygen permeability for the entire container was improved 4.7 times, the moisture permeability for the entire container was improved 1.8 times, and the moisture permeability of each compartment was improved 1.6 times, but this did not satisfy the indicator that improvements be 3 times or higher in the present invention.

From the above facts, in the specific embodiments, a high-frequency capacitive coupling type discharge system and a microwave discharge system were effectively combined to have a mechanism different from the film forming mechanism of each method, and this made it possible to form a high-quality film with good productivity. In this way, it was possible to form a DLC film on a plastic container equipped with partition plates to impart moisture and gas barrier properties.

Further, even with the single system of the high-frequency capacitive coupling type discharge system, it was possible to form a DLC film on a plastic container equipped with partition plates to impart moisture and gas barrier properties.

## Claims

1. A moisture and gas barrier plastic container equipped with partition plates, comprising:
a plastic container equipped with partition plates, wherein a moisture and gas barrier DLC (Diamond Like Carbon) film is formed on inner wall surfaces having an inside/outside relationship with respect to outer wall surfaces of said plastic container, a DLC film is formed on partition plate wall surfaces formed by said partition plates.

2. The moisture and gas barrier plastic container equipped with partition plates described in Claim 1, wherein the DLC film formed on said partition plate wall surfaces is a moisture and gas barrier DLC film.

3. An apparatus for manufacturing a moisture and gas barrier plastic container equipped with partition plates, which is an apparatus for manufacturing a DLC film coated plastic container in which a DLC film is formed by a plasma CVD (Chemical Vapor Deposition) method on inner wall surfaces having an inside/outside relationship with respect to outer wall surfaces of a plastic container equipped with partition plates and partition plate wall surfaces formed by said partition plates, comprising:
a vacuum chamber which surrounds said plastic container and also serves as an external electrode;
a grounded internal electrode which passes through said vacuum chamber and is inserted into the inside of each compartment inside said plastic container formed by said inner wall surfaces and said partition plate wall surfaces;
a high-frequency output supply means connected to said vacuum chamber to generate a source material plasma inside said plastic container; and
a source gas supply means which introduces a source gas into each compartment inside said plastic container.

4. An apparatus for manufacturing a moisture and gas barrier plastic container equipped with partition plates, which is an apparatus for manufacturing a DLC film coated plastic container in which a DLC film is formed by a plasma CVD method on inner wall surfaces having an inside/outside relationship with respect to outer wall surfaces of a plastic container equipped with partition plates and partition plate wall surfaces formed by said partition plates, comprising:
a vacuum chamber which surrounds said plastic container and also serves as an external electrode;
a grounded internal electrode which passes through said vacuum chamber and is inserted into the inside of each compartment inside said plastic container formed by said inner wall surfaces and said partition plate wall surfaces;
a microwave supply means which generates a source gas plasma inside said plastic container by introducing microwaves inside said plastic container;
a high-frequency output supply means which is connected to said vacuum chamber to generate a self-bias voltage at the inner wall surfaces of said plastic container in order to control the ionic incident energy of said source gas plasma for said inner wall surfaces or said partition plate wall surfaces; and
a source gas supply means which introduces a source gas into each compartment inside said plastic container.

5. The apparatus for manufacturing a moisture and gas barrier plastic container equipped with partition plates described in Claim 3 or 4, wherein said source gas supply means is provided with one or more blow out supply holes of said source gas facing said partition plate wall surfaces.

6. The apparatus for manufacturing a moisture and gas barrier plastic container equipped with partition plates described in Claim 3, 4 or 5, wherein said internal electrode inserted into the inside of each compartment inside said plastic container has a plurality of said internal electrodes arranged at prescribed spacings so as to generate said source gas plasma uniformly inside said compartments.

7. The apparatus for manufacturing a moisture and gas barrier plastic container equipped with partition plates described in Claim 6, wherein conductors are provided between said plurality of internal electrodes.

8. The apparatus for manufacturing a moisture and gas barrier plastic container equipped with partition plates described in Claim 3, 4 or 5, wherein said internal electrode inserted into the inside of each compartment inside said plastic container is formed to have a plate-shaped electrode structure so as to generate said source gas plasma uniformly inside said compartments.

9. A method of manufacturing a moisture and gas barrier plastic container equipped with partition plates, which is a method of manufacturing a DLC film coated plastic container in which a DLC film is formed by a plasma CVD method on inner wall surfaces having an inside/outside relationship with respect to outer wall surfaces of a plastic container equipped with partition plates and partition plate wall surfaces formed by said partition plates, comprising the steps of:
housing said plastic container inside a vacuum chamber which also serves as an external electrode so that the outer wall surfaces of said plastic container is roughly in contact with the inner wall surface of said vacuum chamber, and inserting a grounded internal electrode in an insulated state with respect to said vacuum chamber into the inside of each compartment inside said plastic container formed by said inner wall surfaces and said partition plate wall surfaces from the opening of said plastic container; and then
supplying a source gas into each of said compartments inside said plastic container; and
forming a moisture and gas barrier DLC film on said inner wall surfaces of said plastic container and forming a DLC film on said partition plate wall surfaces by supplying a high-frequency output to said vacuum chamber to generate said source gas plasma in each of said compartments.

10. A method of manufacturing a moisture and gas barrier plastic container equipped with partition plates, which is a method of manufacturing a DLC film coated plastic container in which a DLC film is formed by a plasma CVD method on inner wall surfaces having an inside/outside relationship with respect to outer wall surfaces of a plastic container equipped with partition plates and partition plate wall surfaces formed by said partition plates, comprising the steps of:
housing said plastic container inside a vacuum chamber which also serves as an external electrode so that the outer wall surfaces of said plastic container are roughly in contact with the inner wall surface of said vacuum chamber, and inserting a grounded internal electrode in an insulated state with respect to said vacuum chamber into the inside of each compartment inside said plastic container formed by said inner wall surfaces and said partition plate wall surfaces from the opening of said plastic container; and then
supplying a source gas into each of said compartments inside said plastic container; and
forming a moisture and gas barrier DLC film on said inner wall surfaces and forming a DLC film on said partition plate wall surfaces by supplying microwaves inside said plastic container to generate said source gas plasma inside each of said compartments, and roughly simultaneously supplying a high-frequency output to said vacuum chamber to generate a self-bias voltage at said inner wall surfaces of said plastic container.

11. The method of manufacturing a moisture and gas barrier plastic container equipped with partition plates described in Claim 9 or 10, wherein the DLC film formed on said partition plate wall surfaces has moisture and gas barrier properties.

12. The method of manufacturing a moisture and gas barrier plastic container equipped with partition plates described in Claim 9, 10 or 11, wherein the amount of said source gas supplied to said partition plate wall surfaces is 2 ∼ 10 times the amount of said source gas supplied to said inner wall surfaces.
